# EUROPEAN PATENT SPECIFICATION

(11) **EP 4 443 696 B1**
(45) Date of publication and mention of the grant of the patent: **15.07.2026**
(21) Application number: 23857758.9
(22) Date of filing: 24.08.2023
(51) Int. Cl.: H01M 10/643, H01M 10/6563, H01M 10/613, H01M 10/48, H01M 10/44, H02J 7/00, H05K 7/20

(54) **CHARGING AND DISCHARGING DEVICE MAINTAINING ADIABATIC ENVIRONMENT WITHOUT GENERATION OF TEMPERATURE DEVIATION BETWEEN BATTERY CELLS IN CHAMBER**
LADE- UND ENTLADEVORRICHTUNG MIT AUFRECHTERHALTUNG EINER ADIABATISCHEN UMGEBUNG OHNE ERZEUGUNG EINER TEMPERATURABWEICHUNG ZWISCHEN BATTERIEZELLEN IN EINER KAMMER
DISPOSITIF DE CHARGE ET DE DÉCHARGE MAINTENANT UN ENVIRONNEMENT ADIABATIQUE SANS GÉNÉRATION D'ÉCART DE TEMPÉRATURE ENTRE DES CELLULES DE BATTERIE DANS UNE CHAMBRE

(30) Priority: 24.08.2022 KR 20220106043
(43) Date of publication of application: 09.10.2024
(73) Proprietor: LG Energy Solution, Ltd., Seoul 07335 (KR)
(72) Inventor: HAN, Woo Ri, Daejeon 34122 (KR); KIM, Hyoung Kwon, Daejeon 34122 (KR); KWAK, Jin Goo, Daejeon 34122 (KR); LEE, Byeong Hoon, Daejeon 34122 (KR); PARK, Sung Jun, Daejeon 34122 (KR)
(74) Representative: Goddar, Heinz J.
(86) International application number: PCT/KR2023/012582
(87) International publication number: WO 2024/043726

(56) References cited:
- CN-U- 211 351 760
- JP-A- 2019 046 615
- JP-A- 2021 174 647
- KR-A- 20190 012 058
- KR-B1- 101 748 841
- US-A1- 2008 213 652

## Description

### [Technical Field]

This application claims the benefit of priority to Korean Application No. 2022-0106043 filed on August 24, 2022, the disclosure of which is incorporated herein by reference in its entirety.

The present invention relates to a charging and discharging apparatus capable of maintaining a thermally insulated environment with no temperature deviation between battery cells in a chamber and a charging and discharging method thereof. More particularly, the present invention relates to a charging and discharging apparatus that applies a charging and discharging current to a chamber maintained at a constant temperature through air circulation, wherein the charging and discharging apparatus is configured to solve temperature deviation caused by a difference in cooling level of battery cells in the chamber and is configured such that, in order to analyze the actual performance of a high-power battery cell having a high rate discharging condition with a lot of heat generation, a thermally insulated environment without temperature deviation between battery cells is maintained in the chamber, including a cylindrical thermal insulation function to prevent temperature deviation due to direct air circulation, and a charging and discharging method thereof.

### [Background Art]

With rapid improvement in safety and capacity of a lithium secondary battery, which is capable of being charged and discharged, the number of devices that use the lithium secondary battery as an energy source has increased.

With increase in technological development and demand for electric vehicles, the demand for secondary batteries as an energy source has been rapidly increasing.

For example, the lithium secondary battery has been widely used as an energy source for wireless mobile devices, which are small multifunctional products, or wearable devices, which are worn on bodies, and has also been used as an energy source for electric vehicles and hybrid electric vehicles presented as alternatives to existing gasoline and diesel vehicles, which cause air pollution, or as a medium or large battery pack configured to be used in an energy storage system (ESS).

Depending on the shape of a battery case, the lithium secondary battery is classified as a cylindrical secondary battery having an electrode assembly mounted in a cylindrical metal can, a prismatic secondary battery having an electrode assembly mounted in a prismatic metal can, or a pouch-shaped secondary battery having an electrode assembly mounted in a pouch-shaped case made of an aluminum laminate sheet. Thereamong, the cylindrical secondary battery has the advantages of relatively large capacity and structural safety.

An electrode assembly used in a cylindrical secondary battery is wound into a roughly cylindrical shape so as to be appropriately received in a cylindrical can. More specifically, the cylindrical electrode assembly is configured such that a positive electrode, a separator, and a negative electrode are stacked and wound multiple times into a roughly cylindrical shape. Here, the positive electrode is formed by coating a positive electrode plate with a positive electrode active material (e.g., a layered compound including lithium), the separator is made of porous polyethylene (PE) or polypropylene (PP) so as to allow lithium ions to move therethrough, and the negative electrode is formed by coating the surface of a negative electrode plate with a negative electrode active material (e.g., a carbon-based material). Furthermore, a positive electrode tab is connected to the positive electrode plate so as to extend outwards therefrom by a predetermined length, and a negative electrode tab is connected to the negative electrode plate so as to extend outwards therefrom by a predetermined length.

In recent years, a cylindrical lithium ion battery having high energy density has often been used. The demand for such a secondary battery is increasing due to the advantages described above.

Meanwhile, a secondary battery is manufactured through a cell assembly process and a battery activation process, and in a battery activation stage, a battery cell is mounted to a predetermined jig and is charged under conditions required for activation.

Overheating of the battery cell may shorten the lifespan of the battery cell, and when the battery cell explodes due to thermal runaway of the battery cell, a device having the battery cell mounted therein may be affected. Consequently, managing the temperature of the battery cell is an important issue.

In a charging and discharging apparatus for measuring the temperature change of such a battery cell due to charging and discharging thereof, there is a need to solve the phenomenon that the cooling effect on the battery cell is changed depending on the charging and discharging position of the battery cell in the form of convection at the side or upper and lower parts in a chamber due to air circulation.

In addition, temperature measurement is required through a charge and discharge apparatus having a thermal insulation function outside the battery cell to prevent direct air circulation to the cell and maintain constant temperature conditions.

Japanese Patent Publication No. 3057556 discloses a method of charging and discharging a secondary battery, wherein a secondary battery is inserted into each of a plurality of battery support holes with bottoms of a pallet having insertion holes for power terminals formed in a bottom part so as to be supported thereby, and when the secondary battery is charged and discharged by connecting the power terminals to a lower surface and a positive terminal of the secondary battery, the secondary battery inserted in and supported by the battery support hole is pushed upwards from below by a power terminal for charging and discharging so as to protrude from an upper surface of the support hole such that the surface of the secondary battery is exposed, and the secondary battery is charged and discharged while blowing air to the exposed surface of the secondary battery. However, there is no description of a charging and discharging apparatus capable of solving temperature deviations of a plurality of cylindrical batteries.

Chinese Patent Publication No. 207441892 discloses a battery tray including a base made of a cooling material and a clip assembly constituted by a pair of clips, wherein a semicircular recess is provided at one side of the clip assembly. The two clips, which are disposed opposite each other, form a cylindrical clip recess for positioning a battery, and the two opposite clips include a stationary block and a movable block. Disclosed is a charging and discharging apparatus, wherein a base of a clamp assembly extends through a pusher column, two ends of the pusher column are fixed to the base, adjacent clamp assemblies are connected to each other by a spring, and a battery pallet is formed on a low-temperature section of a cold plate. However, there is no description of a charging and discharging apparatus capable of solving temperature deviations of a plurality of cylindrical batteries.

Korean Patent Publication No. 10-2387606 discloses a cylindrical battery cell charging and discharging jig configured to charge and discharge at least one cylindrical battery cell in order to test the at least one cylindrical battery cell, wherein the cylindrical battery cell charging and discharging jig includes a body member and an electrical conduction jig for cylindrical battery cell charging and discharging, and the electrical conduction jig for cylindrical battery cell charging and discharging includes a panel member, a battery cell receiving member, a battery cell energizing unit, and a lifting unit. However, there is no description of a charging and discharging apparatus capable of solving temperature deviations of a plurality of cylindrical batteries.

Japanese Patent Publication No. 3057556 relates to technology for charging and discharging a cylindrical battery cell in the state in which the surface of the cylindrical battery cell is exposed to a blower, Chinese Patent Publication No. 207441892 relates to charging and discharging technology using a base made of a cooling material and a cooling plate, and Korean Patent Publication No. 10-2387606 relates to an electrical conduction jig for cylindrical battery cell charging and discharging. That is, none of the patent documents suggest a charging and discharging apparatus that applies a charging and discharging current into a chamber maintained at a constant temperature through air circulation, wherein the charging and discharging apparatus is configured to solve temperature deviation caused by a difference in cooling level of battery cells in the chamber and is configured such that, in order to analyze the actual performance of a high-power battery cell having a high rate discharging condition with a lot of heat generation, an insulated environment without temperature deviation between battery cells is maintained in the chamber, including a cylindrical thermal insulation function to prevent temperature deviation due to direct air circulation.

### (Prior Art Documents)

(Patent Document 1) Japanese Patent Publication No. 3057556 (2000.04.21)
(Patent Document 2) Chinese Patent Publication No. 207441892 (2018.06.01)
(Patent Document 3) Korean Patent Publication No. 10-2387606 (2022.04.18).
(Patent Document 4) D1, United States Patent Publication No 2008/213652 A1 discloses a container for batteries, with charging/ discharging means and a fan.

### [Disclosure]

### [Technical Problem]

The present invention has been made in view of the above problems, and it is an object of the present invention to provide a charging and discharging apparatus that applies a charging and discharging current into a chamber maintained at a constant temperature through air circulation, wherein the charging and discharging apparatus is configured to solve temperature deviation caused by a difference in cooling level of battery cells in the chamber and is configured such that, in order to analyze the actual performance of a high-power battery cell having a high rate discharging condition with a lot of heat generation, a thermal insulated environment without temperature deviation between battery cells is maintained in the chamber, including a cylindrical thermal insulation function to prevent temperature deviation due to direct air circulation, and a charging and discharging method thereof.

### [Technical Solution]

A charging and discharging apparatus according to the present invention to accomplish the above object includes all the features of independent claim 1. Dependent claims define further advantageous embodiments.

A method for charging and discharging of a charging and discharging apparatus according to the present invention comprises all the features of independent claim 11. Dependent claim 12 defines a further advantageous embodiment.

### [Advantageous Effects]

As is apparent from the above description, a charging and discharging apparatus according to the present invention is capable of charging and discharging cylindrical battery cells without temperature deviation between the cylindrical battery cells through a thermal insulation effect, whereby it is possible to accurately measure the temperature of each of the cylindrical battery cells.

In addition, it is possible to rapidly and accurately determine the state of the cylindrical battery cells, and therefore it is possible to provide a battery cell assembly with improved safety.

### [Description of Drawings]

FIG. 1 is a conceptual view showing that a battery cell and a jig are separated from each other in a charging and discharging apparatus according to the present invention.
FIG. 2 is a conceptual view showing that the jig is rotated so as to be coupled to the battery cell in the charging and discharging apparatus according to the present invention.
FIG. 3 is a conceptual view showing that the jig is moved and coupled to the battery cell in the charging and discharging apparatus according to the present invention.
FIG. 4 is a graph showing end temperatures of a rest period after discharge by charging and discharging position in a chamber before and after application of the jig according to the present invention in comparative examples and examples.
FIG. 5 is a table showing the end temperatures of the rest period after discharge by charging and discharging position in the chamber before and after application of the jig according to the present invention in the comparative examples and the examples.
FIG. 6 is a graph showing change in capacity over charging cycles before and after application of the jig according to the present invention in the comparative examples and the examples.
FIG. 7 is a table showing the change in capacity over charging cycles before and after application of the jig according to the present invention in the comparative examples and the examples.

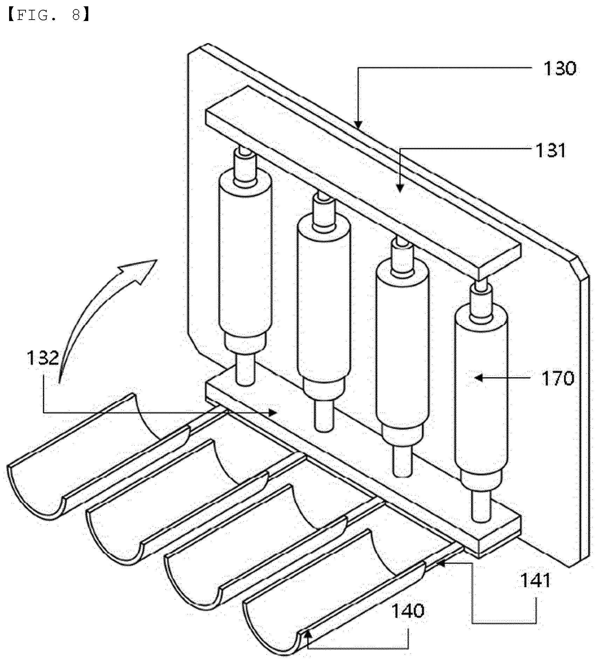

FIG. 8 is a perspective view showing that the battery cell and the jig are separated from each other in the charging and discharging apparatus according to the present invention.

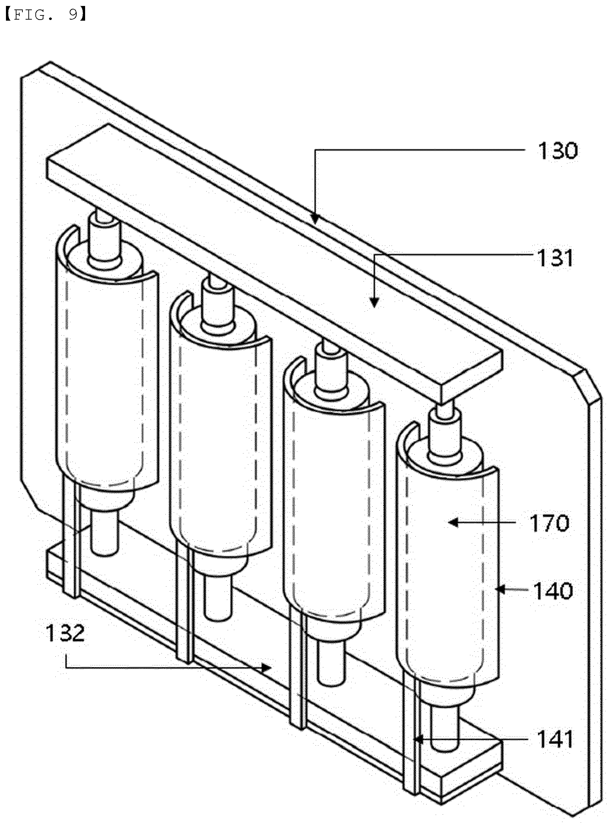

FIG. 9 is a perspective view showing that the battery cell and the jig are coupled to each other in the charging and discharging apparatus according to the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

In addition, a description to embody elements through limitation or addition may be applied to all inventions, unless particularly restricted, and does not limit a specific invention.

Also, in the description of the invention and the claims of the present application, singular forms are intended to include plural forms unless mentioned otherwise.

Also, in the description of the invention and the claims of the present application, "or" includes "and" unless mentioned otherwise. Therefore, "including A or B" means three cases, namely, the case including A, the case including B, and the case including A and B.

Hereinafter, an embodiment of the present invention will be described in detail with reference to the drawings.

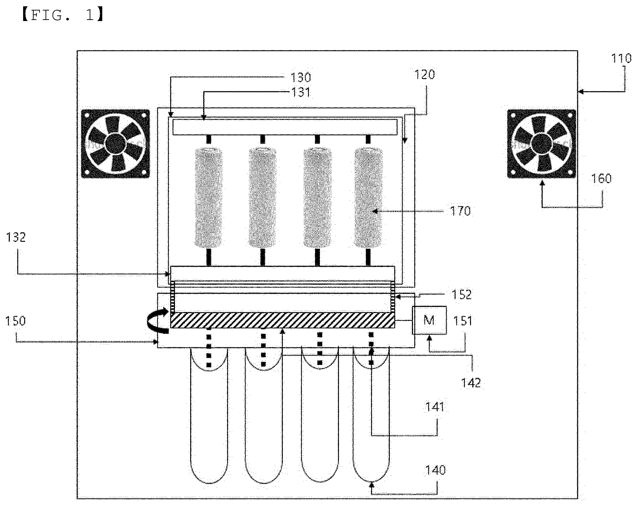

FIG. 1 is a conceptual view showing that a battery cell and a jig are separated from each other in a charging and discharging apparatus according to the present invention.

The charge and discharge apparatus according to the present invention may include a chamber, a main frame formed in the chamber, the main frame being configured to allow a plurality of cylindrical battery cells to be mounted thereon, a charging and discharging means configured to charge or discharge the battery cell mounted on the main frame, a jig configured to be disposed on or removed from an outer surface of each of the battery cells to reduce temperature deviation between the battery cells, a transfer means configured to transfer the jigs, and a blowing means configured to circulate air in the chamber.

The chamber is a space in which the main parts of the charging and discharging apparatus for charging and discharging the cylindrical battery cells are received. The temperature of the space in the chamber must be uniform, and the lack of such temperature uniformity and the presence of a hot spot in a specific zone may cause an error in sensing data of the charging and discharging apparatus.

The main frame is a frame configured to allow cylindrical battery cells to be charged and discharged to be mounted thereon. Other components are operated based on the position of the battery cells on the main frame in order to mount and dismount the battery cells, to perform charging and discharging by the charging and discharging means after mounting, and to add the thermal insulation effect of the battery cells through the jigs before charging and discharging of the battery cells.

It is obvious that the type of the charging and discharging means is not limited as long as the charging and discharging means is capable of charging and discharging the battery cells.

There may be provided a battery cell case connected to the main frame, which is formed in the shape of a plate having a predetermined area, the battery cell case being configured to receive the cylindrical battery cells therein.

There may be provided a battery cell energizing unit configured to energize the cylindrical battery cells with an external power source while pressing upper parts of the cylindrical battery cells such that the cylindrical battery cells received in the battery cell case are fixed.

A lifting unit connected to the main frame may be included, wherein the lifting unit may be configured to lower the battery cell energizing unit toward the cylindrical battery cells such that the cylindrical battery cells are pressed by the battery cell energizing unit or to raise the battery cell energizing unit from the cylindrical battery cells such that pressing of the cylindrical battery cells by the battery cell energizing unit is released.

The battery cell energizing unit is lowered by the lifting unit in the state in which the cylindrical battery cells are received in the battery cell case to simultaneously press a positive electrode terminal, which may be disposed at an upper part of each of the cylindrical battery cells, and a negative electrode terminal, which may be disposed at the upper part or a lower part of each of the cylindrical battery cells, and an external power source is applied to the battery cell energizing unit in the state in which the negative electrode terminal and the positive electrode terminal of each of the cylindrical battery cells are simultaneously pressed by the battery cell energizing unit such that electrical conduction from the external power source to each of the cylindrical battery cells through the battery cell energizing unit is performed, whereby the cylindrical battery cells may be charged and discharged.

According to the invention, charging may be performed in the state in which each of the jigs encloses a corresponding one of the battery cells in order to further thermally insulate the battery cells.

The battery cell energizing unit may include a negative electrode terminal energizing unit configured to achieve electrical conduction between the negative electrode terminal of the cylindrical battery cell and a negative electrode of the external power source while pressing an upper edge or a bottom part of the cylindrical battery cell at which the negative electrode terminal of the cylindrical battery cell is formed.

The battery cell energizing unit may include a positive electrode terminal energizing unit configured to achieve electrical conduction between the positive electrode terminal of the cylindrical battery cell and a positive electrode of the external power source while pressing an upper middle part of the cylindrical battery cell at which the positive electrode terminal of the cylindrical battery cell is formed.

If the negative electrode terminal energizing unit is in contact with an upper part of the cylindrical battery cell, a thermal insulating unit may be disposed between the negative electrode terminal energizing unit and the positive electrode terminal energizing unit.

An elastic body configured to provide elastic force between the battery cell and the thermal insulating unit, the negative electrode terminal energizing unit, or the positive electrode terminal energizing unit may be formed at a predetermined position of the thermal insulating unit, the negative electrode terminal energizing unit, or the positive electrode terminal energizing unit.

The elastic body may be in the form of a spring.

A negative voltage sensor configured to detect the voltage of the negative electrode and a positive voltage sensor configured to detect the voltage of the positive electrode when electrical conduction is achieved as the result of the negative electrode terminal energizing unit or the positive electrode terminal energizing unit coming into contact with the negative electrode terminal and the positive electrode terminal, respectively, may be further included.

Additionally, a temperature sensor configured to detect the temperature of the battery cell being charged or discharged at a predetermined position of the battery cell may be included.

It is obvious that the type of the negative electrode terminal energizing unit or the positive electrode terminal energizing unit is not limited as long as the negative electrode terminal energizing unit or the positive electrode terminal energizing unit is capable of contacting the terminal of the battery cell. Preferably, the negative electrode terminal energizing unit or the positive electrode terminal energizing unit may have a terminal contact surface having a plurality of protrusions formed thereon.

For temperature uniformity of the cylindrical battery cell, the battery cell may be rotated or periodically repositioned during charging and discharging.

A battery cell rotating unit may be included in order to rotate and periodically reposition the battery cell.

The lifting unit may include an external force applying body configured to allow external force to be applied thereto and a lifting body connected between the external force applying body and the positive electrode terminal energizing unit, the lifting body being configured to receive the external force applied to the external force applying body and to lift the positive electrode terminal energizing unit.

When external force is applied to the external force applying body and the lifting body is primarily lowered in the state in which the cylindrical battery cell is received in the battery cell case, the positive electrode terminal energizing unit connected to the lifting body is lowered along with the insulating unit and the negative electrode terminal energizing unit, whereby the upper edge of the cylindrical battery cell abuts an inclined alignment body.

When external force is further applied to the external force applying body and the lifting body is secondarily lowered in the state in which the upper edge of the cylindrical battery cell abuts the inclined alignment body, the thermal insulating unit and the positive electrode terminal energizing unit may be relatively further lowered.

The negative electrode terminal energizing unit may be raised in a state of pressing the negative electrode terminal formed at the upper edge of the cylindrical battery cell, whereby restoring force may be accumulated in the elastic body on the side of negative electrode terminal energizing unit, and the positive electrode terminal energizing unit may press the positive electrode terminal of the cylindrical battery cell.

Consequently, the negative electrode terminal energizing unit and the positive electrode terminal energizing unit may simultaneously press the negative electrode terminal and the positive electrode terminal of the cylindrical battery cell.

When electrical conduction between the negative electrode terminal energizing unit and the negative electrode of the external power source and electrical conduction between the positive electrode terminal energizing unit and the positive electrode of the external power source are performed in the state in which the negative electrode terminal and the positive electrode terminal of the cylindrical battery cell are simultaneously pressed by the negative electrode terminal energizing unit and the positive electrode terminal energizing unit, the cylindrical battery cell may be charged and discharged.

The battery cell may be mounted on the main frame in a state of being coupled to an upper charging and discharging portion and a lower charging and discharging portion of the charging and discharging means.

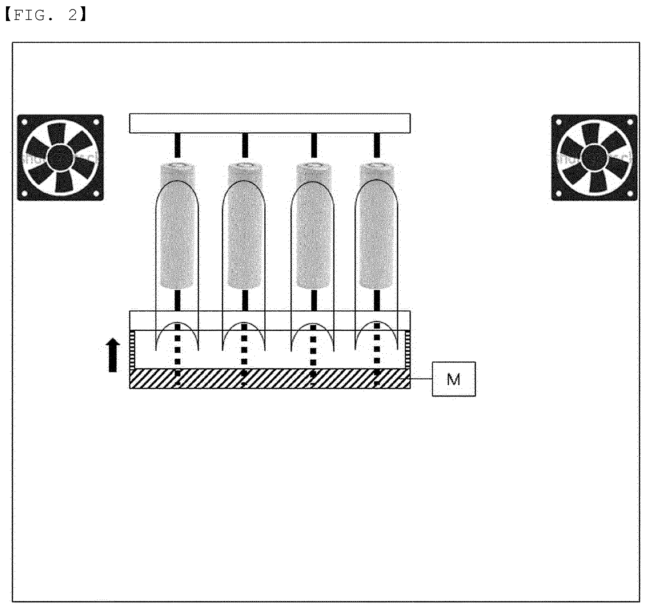

FIG. 2 is a conceptual view showing that the jig is rotated so as to be coupled to the battery cell in the charging and discharging apparatus according to the present invention.

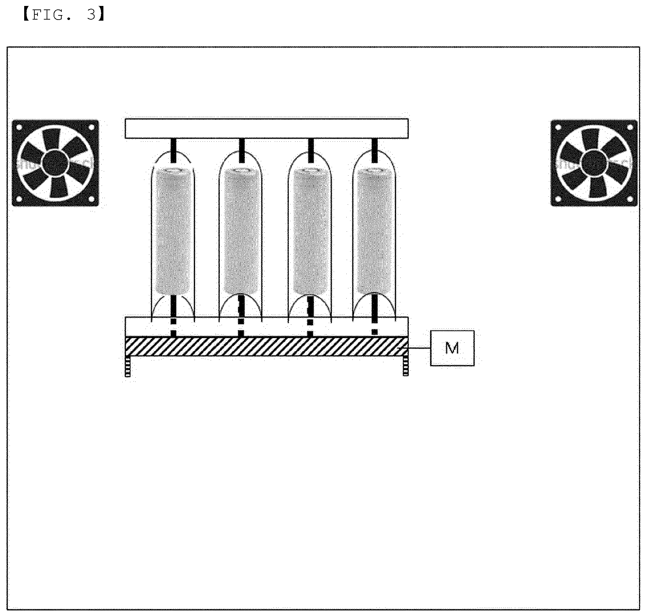

FIG. 3 is a conceptual view showing that the jig is moved and coupled to the battery cell in the charging and discharging apparatus according to the present invention.

The transfer means may simultaneously transfer the plurality of jigs such that each of the jigs is disposed at a predetermined position on an outer surface of a corresponding one of the plurality of cylindrical battery cells or is removed therefrom.

The transfer means may include a jig support configured to support each of the jigs and a subframe to which the plurality of jig supports is fixed.

The transfer means may include a rotating portion configured to rotate the jig supports and a moving portion configured to move the subframe.

At least one blowing means may be installed on at least one surface of the chamber.

The blowing means may be a fan capable of circulating air.

The jig may have a structure configured to receive the battery cell.

The shape of the jig may be circular, angular, or hemispherical, and the shape of the jig is not limited as long as it is possible to receive the battery cell, thereby exhibiting the thermal insulation effect.

The jig may be formed in the same shape as the outer shape of the battery cell, and may expose 5% to 60% of the outer surface area of the battery cell.

The jig may be made of a thermal insulating material.

The jig may be easy to mold and may have temperature resistance, chemical resistance, and electrical insulation.

The jig may be made of plastic, preferably a thermosetting resin. More preferably, the jig is made of Bakelite.

Hereinafter, the present invention will be described with reference to examples. These examples are provided only for easier understanding of the present invention and should not be construed as limiting the category of the present invention.

### <Example 1>

Cylindrical battery cells having jigs applied thereto were charged and discharged in five channels, in each of which a charge and discharge means was installed. A 45-minute rest period was given after completion of discharging, and the rest end temperature of each battery cell was measured.

Charging to 4.225V was performed under charging conditions of 3.6C, 2.4C, 1.2C, and 0.6C, and discharging to 2.5V was performed under discharging conditions of 2.5C.

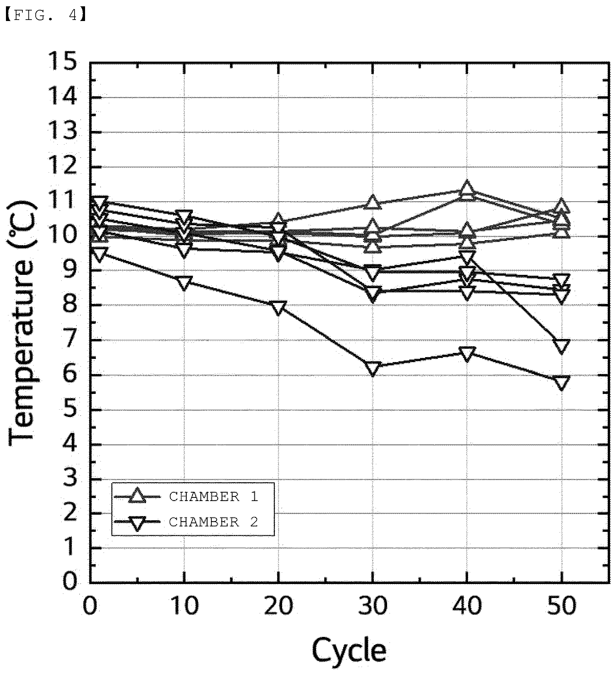

The triangular graph of chamber 1 in FIG. 4 shows that the temperature deviation is low with the jigs applied.

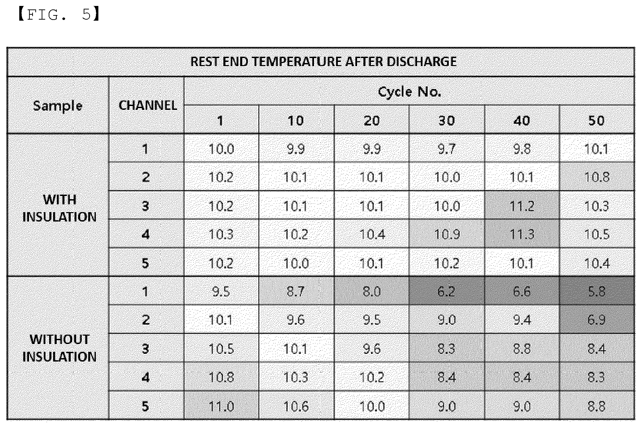

FIG. 5 shows the rest end temperature after discharge for each channel due to an increase in number of cycles for the battery cells with the jigs applied to form thermal insulating environments. It can be seen that there is no significant difference in the temperature values of the battery cells for each cycle and each channel.

### <Comparative Example 1>

The experiment was performed under the same conditions as in Example 1 except that the conditions of Example 1 and the jigs were not applied to cylindrical battery cells.

It can be seen from the inverted triangle graph of chamber 2 in FIG. 4 that the temperature deviation of the battery cells is higher than in Example 1.

FIG. 5 shows the rest end temperature after discharge for each channel due to an increase in number of cycles for the battery cells without the jigs applied, thereby having no thermal insulating environments. It can be seen that the temperature values of the battery cells for each cycle and each channel are significantly different compared to Example 1. In particular, for channel 1, it can be seen that the relatively low rest end temperature appears as the number of cycles increases.

### <Example 2>

A cylindrical battery cell having a jig applied thereto was charged and discharged in a channel, in which a charge and discharge means was installed. The cylindrical battery cell with thermal insulation was charged and discharged for 128 cycles and the capacity change of the battery cell was measured.

Charging to 4.2V was performed under charging conditions of 1.5C, and discharging to 2.5V was performed under discharging conditions of 2.5C.

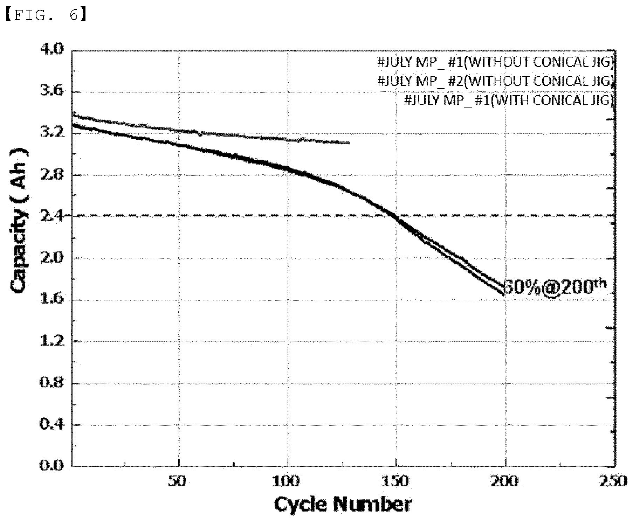

It can be seen from FIG. 6 that the capacity of the battery cell having the conical jig applied thereto is not significantly decreased over 128 cycles.

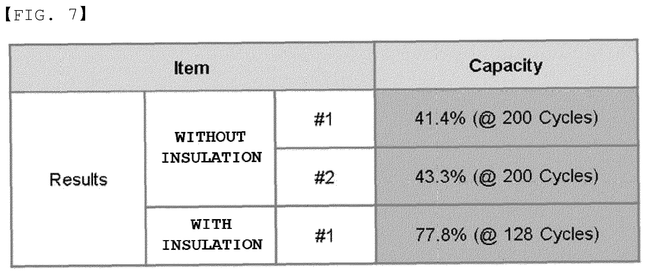

It can be seen from FIG. 7 that the battery cell of Example 2 with a thermally insulated environment retains a capacity of 77.8% even after 128 cycles.

### <Comparative Example 2>

Cylindrical battery cells were charged and discharged in channels, in each of which a charge and discharge means was installed, under the same conditions as in Example 2 except that the jigs were not applied. The cylindrical battery cells without insulation were charged and discharged for 200 cycles and the capacity change of each of the battery cells was measured.

It can be seen from FIG. 6 that the capacity of each of the battery cells without the conical jigs is significantly reduced from 100 cycles over 200 cycles.

It can be seen from FIG. 7 that battery cell 1 of Comparative Example 2 with no thermally insulated environment retains a capacity of 41.4% after 200 cycles and that battery cell 2 of Comparative Example 2 with no thermally insulated environment retains a capacity of 43.3% after 200 cycles.

Those skilled in the art to which the present invention pertains will appreciate that various applications and modifications are possible.

### (Description of Reference Numerals)

- 100:: Charging and discharging apparatus
- 110:: Chamber
- 120:: Main frame
- 130:: Charging and discharging means
- 131:: Upper charging and discharging portion
- 132:: Lower charging and discharging portion
- 140:: Jig
- 150:: Transfer means
- 151:: Jig support
- 152:: Subframe
- 153:: Rotating portion
- 154:: Moving portion
- 160:: Blowing means
- 170:: Battery cell

## Claims

1. A charging and discharging apparatus (100) comprising:
a chamber (110);
a main frame 120) formed in the chamber (110) and configured to allow a plurality of cylindrical battery cells (170) to be mounted thereon;
a charging and discharging means (130) configured to charge or discharge the battery cells (170) mounted on the main frame (120);
jigs (140), wherein each of the jigs is configured to be disposed on an outer surface of a corresponding one of the battery cells (170) so as to enclose the corresponding one of the battery cells (170) in order to further thermally insulate the battery cells (170), to reduce a deviation between temperatures of the battery cells (170) caused by a difference in cooling levels of the battery cells in the chamber;
a transfer means (150) configured to transfer the jigs (140); and
a blowing means (160) configured to circulate air in the chamber (110).

2. The charging and discharging apparatus (100) according to claim 1, wherein the battery cells (170) are mounted on the main frame (120) in a state of being coupled to an upper charging and discharging portion (131) and a lower charging and discharging portion (132) of the charging and discharging means (130).

3. The charging and discharging apparatus(100) according to claim 1, wherein the transfer means (150) simultaneously transfers the plurality of jigs (140) such that each of the jigs (140) is disposed at a predetermined position on an outer surface of a corresponding one of the plurality of cylindrical battery cells (170) or is removed therefrom.

4. The charging and discharging apparatus(100) according to claim 3, wherein the transfer means (150) comprises:
a jig support (151) configured to support each of the jigs (140); and
a subframe to which a plurality of the jig supports (151) is fixed.

5. The charging and discharging apparatus(100) according to claim 4, wherein the transfer means (150) comprises:
a rotating portion (131) configured to rotate the jig supports (151); and
a moving portion (154) configured to move the subframe.

6. The charging and discharging apparatus(100) according to claim 1, wherein the charging and discharging apparatus comprises one or more of the blowing means (160) installed on at least one surface of the chamber (110).

7. The charging and discharging apparatus(100) according to claim 1, wherein the jig (140) has a structure configured to receive the each of the battery cells (170).

8. The charging and discharging apparatus(100) according to claim 7, wherein the jig (140) is formed in the same shape as an outer shape of the each of the battery cells (170), and exposes 5% to 60% of an outer surface area of the each of the battery cells (170).

9. The charging and discharging apparatus(100) according to claim 1, wherein the jig (140) is made of an thermal insulating material.

10. The charging and discharging apparatus(100) according to claim 1, wherein the charging and discharging apparatus further comprises:
a charging and discharging controller configured to control charging or discharging of the charging and discharging means (130);
a data measurement unit configured to collect data of one or more of voltage, resistance, temperature, charging and discharging cycles, and capacity of the battery cell (170); and
a data display unit configured to externally output or display the data.

11. A method for charging and discharging using a charging and discharging apparatus(100) for cylindrical battery cells (170), the method comprising:
a first step of mounting a plurality of cylindrical battery cells (170) on a main frame (120) in a chamber (110);
a second step of rotating jigs (140) fixed to jig supports (151) to locate the jigs at positions equidistantly spaced apart from the battery cells (170);
a third step of moving, by a transfer means (150), a subframe to which the jig supports (151) are fixed such that each of the jig (140)s is disposed on an outer surface of a corresponding one of the battery cells (170) so as to enclose the corresponding one of the battery cells (170) in order to further thermally insulate the battery cells (170);
a fourth step of operating a blowing means (160) to circulate air; and
a fifth step of charging or discharging the battery cell (170) for predetermined cycles using a charging and discharging means (130),
wherein the jigs (140) are configured to reduce a deviation between temperatures of the battery cells (170) caused by a difference in cooling levels of the battery cells in the chamber.

12. The method according to claim 11, wherein the fifth step comprises:
controlling, by a charging and discharging controller, charging or discharging of the charging and discharging means (130);
collecting, by a data measurement unit, data of one or more of voltage, resistance, temperature, charging and discharging cycles, and capacity of the battery cell (170); and
externally outputting or displaying, by a data display unit, the data.

## Patentansprüche

1. Lade- und Entladevorrichtung (100), umfassend:
eine Kammer (110);
einen Hauptrahmen (120), der in der Kammer (110) ausgebildet und dazu eingerichtet ist, dass eine Vielzahl von zylindrischen Batteriezellen (170) daran montiert werden kann;
ein Lade- und Entlademittel (130), das dazu eingerichtet ist, die an dem Hauptrahmen (120) montierten Batteriezellen (170) zu laden oder zu entladen;
Aufnahmen (140), wobei jede der Aufnahmen dazu eingerichtet ist, an einer Außenfläche einer entsprechenden der Batteriezellen (170) angeordnet zu werden, um die entsprechende der Batteriezellen (170) zu umschließen, um die Batteriezellen (170) zusätzlich thermisch zu isolieren, um eine Abweichung zwischen Temperaturen der Batteriezellen (170), die durch einen Unterschied in Kühlungsgraden der Batteriezellen in der Kammer verursacht wird, zu verringern;
ein Transfereinrichtung (150), die dazu eingerichtet ist, die Aufnahmen (140) zu transferieren; und
ein Gebläsemittel (160), das dazu eingerichtet ist, Luft in der Kammer (110) umzuwälzen.

2. Lade- und Entladevorrichtung (100) nach Anspruch 1, wobei die Batteriezellen (170) in einem Zustand an dem Hauptrahmen (120) montiert sind, in dem sie mit einem oberen Lade- und Entladeabschnitt (131) und einem unteren Lade- und Entladeabschnitt (132) des Lade- und Entlademittels (130) gekoppelt sind.

3. Lade- und Entladevorrichtung (100) nach Anspruch 1, wobei die Transfereinrichtung (150) die Vielzahl von Aufnahmen (140) gleichzeitig derart transferiert, dass jede der Aufnahmen (140) an einer vorbestimmten Position an einer Außenfläche einer entsprechenden der Vielzahl von zylindrischen Batteriezellen (170) angeordnet oder davon entfernt wird.

4. Lade- und Entladevorrichtung (100) nach Anspruch 3, wobei die Transfereinrichtung (150) umfasst:
eine Aufnahmehalterung (151), die dazu eingerichtet ist, jede der Aufnahmen (140) zu halten; und
einen Hilfsrahmen, an dem eine Vielzahl der Aufnahmehalterungen (151) befestigt ist.

5. Lade- und Entladevorrichtung (100) nach Anspruch 4, wobei die Transfereinrichtung (150) umfasst:
einen Drehabschnitt (131), der dazu eingerichtet ist, die Aufnahmehalterungen (151) zu drehen; und
einen Bewegungsabschnitt (154), der dazu eingerichtet ist, den Hilfsrahmen zu bewegen.

6. Lade- und Entladevorrichtung (100) nach Anspruch 1, wobei die Lade- und Entladevorrichtung eines oder mehrere der Gebläsemittel (160) umfasst, die an mindestens einer Fläche der Kammer (110) installiert sind.

7. Lade- und Entladevorrichtung (100) nach Anspruch 1, wobei die Aufnahme (140) eine Struktur aufweist, die dazu eingerichtet ist, die jeweilige der Batteriezellen (170) aufzunehmen.

8. Lade- und Entladevorrichtung (100) nach Anspruch 7, wobei die Aufnahme (140) in derselben Form wie eine Außenform der jeweiligen der Batteriezellen (170) ausgebildet ist und 5 % bis 60 % eines Außenflächenbereichs der jeweiligen der Batteriezellen (170) freilegt.

9. Lade- und Entladevorrichtung (100) nach Anspruch 1, wobei die Aufnahme (140) aus einem thermisch isolierenden Material hergestellt ist.

10. Lade- und Entladevorrichtung (100) nach Anspruch 1, wobei die Lade- und Entladevorrichtung ferner umfasst:
eine Lade- und Entladesteuerung, die dazu eingerichtet ist, ein Laden oder Entladen des Lade- und Entlademittels (130) zu steuern;
eine Datenmesseinheit, die dazu eingerichtet ist, Daten von einem oder mehreren von Spannung, Widerstand, Temperatur, Lade- und Entladezyklen und Kapazität der Batteriezelle (170) zu erfassen; und
eine Datenanzeigeeinheit, die dazu eingerichtet ist, die Daten nach außen auszugeben oder anzuzeigen.

11. Verfahren zum Laden und Entladen unter Verwendung einer Lade- und Entladevorrichtung (100) für zylindrische Batteriezellen (170), wobei das Verfahren umfasst:
einen ersten Schritt des Montierens einer Vielzahl von zylindrischen Batteriezellen (170) an einem Hauptrahmen (120) in einer Kammer (110);
einen zweiten Schritt des Drehens von Aufnahmen (140), die an Aufnahmehalterungen (151) befestigt sind, um die Aufnahmen an Positionen anzuordnen, die von den Batteriezellen (170) gleich beabstandet sind;
einen dritten Schritt des Bewegens, durch eine Transfereinrichtung (150), eines Hilfsrahmens, an dem die Aufnahmehalterungen (151) befestigt sind, derart, dass jede der Aufnahmen (140) an einer Außenfläche einer entsprechenden der Batteriezellen (170) angeordnet wird, um die entsprechende der Batteriezellen (170) zu umschließen, um die Batteriezellen (170) zusätzlich thermisch zu isolieren;
einen vierten Schritt des Betreibens eines Gebläsemittels (160), um Luft umzuwälzen; und
einen fünften Schritt des Ladens oder Entladens der Batteriezelle (170) für vorbestimmte Zyklen unter Verwendung eines Lade- und Entlademittels (130),
wobei die Aufnahmen (140) dazu eingerichtet sind, eine Abweichung zwischen Temperaturen der Batteriezellen (170), die durch einen Unterschied in Kühlungsgraden der Batteriezellen in der Kammer verursacht wird, zu verringern.

12. Verfahren nach Anspruch 11, wobei der fünfte Schritt umfasst:
Steuern, durch eine Lade- und Entladesteuerung, eines Ladens oder Entladens des Lade- und Entlademittels (130);
Erfassen, durch eine Datenmesseinheit, von Daten von einem oder mehreren von Spannung, Widerstand, Temperatur, Lade- und Entladezyklen und Kapazität der Batteriezelle (170); und
externes Ausgeben oder Anzeigen, durch eine Datenanzeigeeinheit, der Daten.

## Revendications

1. Appareil de charge et décharge (100) comprenant :
une chambre (110) ;
un châssis principal (120) formé dans la chambre (110), et configuré pour permettre le montage dessus d'une pluralité de cellules de batteries cylindriques (170) ;
un dispositif de charge et décharge (130) configuré pour charger ou décharger les cellules de batteries (170) montées sur le châssis principal (120) ;
des gabarits (140), chacun des gabarits étant configuré pour être disposé sur une surface extérieure d'une cellule correspondante des cellules de batterie (170) de façon à envelopper la cellule correspondante des cellules de batterie (170) afin de renforcer l'isolation thermique des cellules de batterie (170), pour réduire un écart entre des températures des cellules de batterie (170) causé par une différence des niveaux de refroidissement des cellules de batterie dans la chambre ;
un dispositif de transfert (150) configuré pour transférer les gabarits (140) ; et
un dispositif de soufflage (160) configuré pour effectuer la circulation de l'air dans la chambre (110).

2. Appareil de charge et décharge (100) selon la revendication 1, les cellules de batterie (170) étant montées sur le châssis principal (120) dans un état comportant leur accouplement à une partie supérieure de charge et décharge (131) et une partie inférieure de charge et décharge (132) du dispositif de charge et décharge (130).

3. Appareil de charge et décharge (100) selon la revendication 1, le dispositif de transfert (150) transférant simultanément la pluralité de gabarits (140) de sorte que chacun des gabarits (140) soit disposé dans une position prédéterminée sur une surface extérieure d'une cellule correspondante de la pluralité de cellules de batterie cylindrique (170) ou en soit enlevé.

4. Appareil de charge et décharge (100) selon la revendication 3, le dispositif de transfert (150) comprenant :
un support de gabarit (151) configuré pour supporter chacun des gabarits (140) ; et
un faux-châssis sur lequel est fixée une pluralité de supports de gabarit (151).

5. Appareil de charge et décharge (100) selon la revendication 4, le dispositif de transfert (150) comprenant :
une partie rotative (131) configurée pour faire tourner les supports de gabarit (151) ; et
une partie mobile (154) configurée pour déplacer le faux-châssis.

6. Appareil de charge et décharge (100) selon la revendication 1, l'appareil de charge et décharge comprenant un ou plusieurs des dispositifs de soufflage (160) installés sur au moins une surface de la chambre (110).

7. Appareil de charge et décharge (100) selon la revendication 1, la structure du gabarit (140) étant configurée pour recevoir chacune des cellules de batterie (170).

8. Appareil de charge et décharge (100) selon la revendication 7, le gabarit (140) étant réalisé avec la même forme qu'une forme extérieure de chacune des cellules de batterie (170), et exposant de 5% à 60% d'une superficie extérieure de chacune des cellules de batterie (170).

9. Appareil de charge et décharge (100) selon la revendication 1, le gabarit (140) étant réalisé avec un matériau thermo-isolant.

10. Appareil de charge et décharge (100) selon la revendication 1, l'appareil de charge et décharge comprenant en outre :
un régulateur de charge et décharge configuré pour la régulation de la charge ou de la décharge du dispositif de charge et décharge (130) ;
un dispositif de mesure des données configuré pour la collecte de données d'un ou plusieurs des suivants : tension, résistance, température, cycles de charge et décharge, et capacité de la cellule de batterie (170) ; et
un dispositif d'affichage de données configuré pour émettre ou afficher extérieurement les données.

11. Procédé de charge et décharge faisant usage d'un appareil de charge et décharge (100) pour cellules de batterie cylindrique (170), le procédé comprenant :
une première étape de montage d'une pluralité de cellules de batteries cylindriques (170) sur un châssis principal (120) dans une chambre (110) ;
une deuxième étape de rotation de gabarits (140) fixés sur des supports de gabarit (151) pour positionner les gabarits dans des positions espacées de façon équidistante des cellules de batterie (170) ;
une troisième étape de déplacement, par un dispositif de transfert (150), d'un faux-châssis sur lequel sont fixés les supports de gabarit (151) de sorte que chacun des gabarits (140) soit disposé sur une surface extérieure d'une cellule correspondante des cellules de batterie (170) de façon à envelopper la cellule correspondante des cellules de batterie (170) afin de renforcer l'isolation thermique des cellules de batterie (170) ;
une quatrième étape d'utilisation d'un dispositif de soufflage (160) pour effectuer la circulation de l'air ; et
une cinquième étape de charge ou de décharge de la cellule de batterie (170) pendant des cycles prédéterminés à l'aide d'un dispositif de charge et décharge (130),
les gabarits (140) étant configurés pour réduire un écart entre des températures des cellules de batterie (170) causé par une différence des niveaux de refroidissement des cellules de batterie dans la chambre.

12. Procédé selon la revendication 11, la cinquième étape comprenant :
la régulation, par un régulateur de charge et décharge, de la charge ou de la décharge du dispositif de charge et décharge (130) ;
la collecte, par un dispositif de mesure des données, de données d'un ou plusieurs des suivants : tension, résistance, température, cycles de charge et décharge, et capacité de la cellule de batterie (170) ; et
l'émission ou l'affichage extérieurs des données par un dispositif d'affichage des données.
